# EUROPEAN PATENT SPECIFICATION

(11) **EP 3 683 826 B1**
(45) Date of publication and mention of the grant of the patent: **21.06.2023**
(21) Application number: 20150559.1
(22) Date of filing: 07.01.2020
(51) Int. Cl.: H01L 21/56, H01L 23/31, H01L 23/544, B29C 45/14, G01D 11/24

(54) **SENSOR PACKAGE, SENSOR ASSEMBLY, AND METHOD OF FABRICATION**
SENSORGEHÄUSE, SENSORANORDNUNG UND HERSTELLUNGSVERFAHREN
BOÎTIER DE CAPTEUR, ENSEMBLE CAPTEUR ET PROCÉDÉ DE FABRICATION

(30) Priority: 15.01.2019 US 201916247827
(43) Date of publication of application: 22.07.2020
(73) Proprietor: NXP B.V., 5656 AG Eindhoven (NL)
(72) Inventor: OFFERMANN, Bernd, Redhill, Surrey RH1 1QZ (GB)
(74) Representative: Hardingham, Christopher Mark

(56) References cited:
- JP-A- 2005 331 296
- US-A1- 2007 187 869
- US-A1- 2008 287 008
- US-A1- 2011 175 598
- US-A1- 2018 269 165
- US-B2- 8 623 254

## Description

### TECHNICAL FIELD OF THE INVENTION

The present invention relates generally to sensor assemblies. More specifically, the present invention relates to a method of fabricating the sensor assembly.

### BACKGROUND OF THE INVENTION

Sensors are widely used in automotive, airplane and aerospace, manufacturing and machinery, medicine, robotics, and many other applications. A sensor package may include the sensing device, as well as associated electrical components integrated as a single package and encapsulated in an encapsulating material. Insulation of the sensor package, connection cables, and mechanical components is sometimes achieved by an injection molding process, also referred to as overmolding. To retain the sensor package in position within a mold cavity of a mold tool during the overmolding process, a separate support (alternatively referred to as a carrier, inlay, and the like) may be used. This support is thus overmolded with an overmold material (e.g., a thermoplastic or thermosetting polymer) along with the sensor package and remains part of a sensor assembly. This separate support increases the complexity and, commensurately, the cost of a sensor assembly. Further, delamination can occur between the support and the overmold material thereby potentially enabling external contaminants into the sensor assembly and decreasing the reliability of such a sensor assembly, especially in harsh operational environments.
United States Patent application publication number US 2008/0287008 discloses an electronic device having voltage present case, and a molding tool, in which the device includes an electronic circuit section a case and the connector housing. The electronic circuit section includes a connector terminal. The case seals the electronic circuit section in such a manner that the connector terminal protrudes to an outside of the case. The connector housing is integrated with the case and has an approximately cylindrical shape to surround an outer circumference of the connector terminal. The case and the connector housing are made of resin with a molding tool by filling resin into a case cavity and a connector-housing cavity of the molding tool in a state where the electronic circuit section is held by a holding portion of the molding tool. US2007187869 discloses a method for forming a sensor assembly comprising: retaining a sensor package in a cavity of a mold tool, the sensor package including a sensor die and connector pins, the retaining operation comprising receiving an alignment bar of an alignment tool, performing an overmolding process to fill the cavity with an overmold material to form the sensor assembly, wherein the performing operation comprises: executing an initial phase of the overmolding process to secure the sensor package in the mold tool with the overmold material and retracting the alignment bar away from the sensor package.

### SUMMARY

The invention is defined in the independent claims, and embodiments are further described in the dependent claims.

### BRIEF DESCRIPTION OF THE DRAWINGS

The accompanying figures in which like reference numerals refer to identical or functionally similar elements throughout the separate views, the figures are not necessarily drawn to scale, and which together with the detailed description below are incorporated in and form part of the specification, serve to further illustrate various embodiments and to explain various principles and advantages all in accordance with the present invention.
FIG. 1 shows a side view of a sensor package in accordance with an example not forming part of the present invention.
FIG. 2 shows a plan view of the sensor package;
FIG. 3 shows a perspective view of the sensor package;
FIG. 4 shows a perspective view of a sensor assembly in accordance with an example not forming part of the present invention;
FIG. 5 shows a side sectional view of the sensor assembly;
FIG. 6 shows a perspective view of an alignment tool for retaining the sensor package in a mold tool during overmolding to produce the sensor assembly according to an example not forming part of the present invention;
FIG. 7 shows a rear, plan view of the alignment tool;
FIG. 8 shows a flowchart of a sensor assembly fabrication process in accordance with the present invention;
FIG. 9 shows an initial stage of the sensor assembly fabrication process according to the present invention;
FIG. 10 show a subsequent stage of the fabrication process following the stage illustrated in FIG. 9;
FIG. 11 shows a side perspective view of a sensor/cable subassembly in a mold tool according to the present invention;
FIG. 12 shows a side perspective view of the sensor/cable subassembly in the mold tool following an overmolding process according to the present invention;
FIG. 13 shows a perspective view of a sensor package in accordance with an example not forming part of the present invention;
FIG. 14 shows a perspective view of another sensor assembly, being an example not forming part of the present invention;
FIG. 15 shows a rear perspective view of the sensor assembly of FIG. 14;
FIG. 16 shows a sectional view of the sensor assembly of FIG. 14;
FIG. 17 shows a perspective view of the sensor package of FIG. 13 being inserted into a pin support;
FIG. 18 shows a rear perspective view of the pin support;
FIG. 19 shows a perspective view of the sensor package of FIG. 13 retained by the alignment tool of FIG. 6; and
FIG. 20 shows another perspective view of the sensor package of FIG. 13 retained by the alignment tool of FIG. 6.

### DETAILED DESCRIPTION

In overview, the present disclosure concerns a sensor package, sensor assembly, and claims a method of fabricating the sensor assembly using a direct overmolding technique that does not require overmolding a support into the sensor assembly (e.g., forming a premolded support). In particular, the sensor package is equipped with a special feature, referred to herein as a notch region. The notch region can be used for alignment and secure retention of the sensor package during an overmolding process. The notch region is at the die side of the sensor package and is deep enough to accommodate an alignment bar of an alignment tool used with the mold tool. This can ensure that the sensitive area of the sensor package (e.g., the reading point of the sensor) is close to the surface of the overmolded sensor assembly. Further, the sensor package can be equipped with connector pins. In some embodiments, the connector pins may be connected with conductors of a cable, and this connection junction may also be overmolded with the overmold material for protection of the connection junction from an external environment. The various inventive concepts and principles embodied in the sensor package, sensor assembly, and method of fabrication may thus enable improved fabrication and cost efficiency, as well as enhanced sensor reliability.

The instant disclosure is provided to further explain in an enabling fashion at least one embodiment in accordance with the present invention. The disclosure is further offered to enhance an understanding and appreciation for the inventive principles and advantages thereof, rather than to limit in any manner the invention. The invention is defined solely by the appended claims including any amendments made during the pendency of this application.

It should be understood that the use of relational terms, if any, such as first and second, top and bottom, and the like are used solely to distinguish one from another entity or action without necessarily requiring or implying any actual such relationship or order between such entities or actions. Furthermore, some of the figures may be illustrated using various shading and/or hatching to more clearly distinguish the different components from one another.

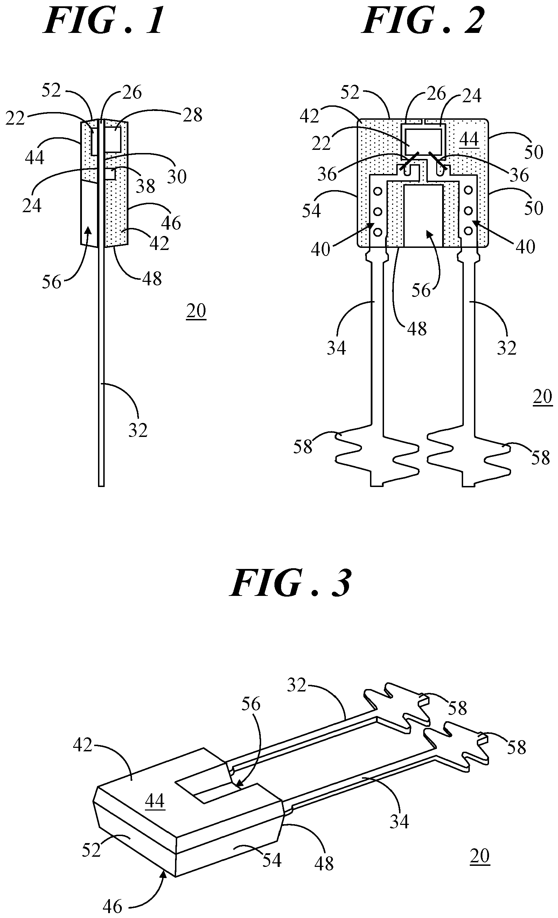

Referring to FIGs. 1-3, FIG. 1 shows a side view of a sensor package 20 in accordance with an an example not forming part of the present invention but useful for understanding it. FIG. 2 shows a plan view of sensor package 20, and FIG. 3 shows a perspective view of sensor package 20. Sensor package 20 includes a sensor die 22 coupled to a first side 24 of a die pad 26. One or more auxiliary components 28 may be coupled to a second side 30 of die pad 26. First and second connector pins 32, 34 are electrically connected to bond pads (not visible) on sensor die 22 via bond wires 36. In some configurations, a capacitor 38 may interconnect distal ends 40 of first and second connector pins 32, 34.

Sensor die 22, die pad 26, auxiliary components 28, capacitor 38, distal ends 40 of first and second connector pins 32, 34, and bond wires 36 are located in a housing 42. Housing 42 is represented in FIGs. 1 and 2 by a stippled pattern in order to distinguish it from the various other components. Additionally, the various components located within housing 42 are visible in FIGs. 1 and 2 for clarity. However, it should be understood that the components within housing 42 may not actually be visible in a manufactured sensor package 20 as shown in FIG. 3.

Housing 42 includes first and second surfaces 44, 46 spaced apart from one another by first, second, third, and fourth sidewalls 48, 50, 52, 54, respectively. Housing 42 may be an epoxy resin thermoset material or any other suitable encapsulating material. Alternatively, housing 42 may be any other suitable case or enclosure in which sensor die 22, die pad 26, auxiliary components 28, capacitor 38, distal ends 40 of first and second connector pins 32, 34, and bond wires 36 may be located. Housing 42 includes a notch region 56 extending into first surface 44 of housing 42 such that a material portion of housing 42 is absent at first sidewall 48 and at first surface 44 of housing 42. Although, housing 42 is illustrated in FIGs. 1 and 2 with a stippled pattern, notch region 56 is not stippled in order to better visualize it. However, the portion of housing 42 surrounding notch region 56 includes sidewalls and a bottom surface (best seen in FIG. 3) so that the components within sensor package 20 are fully enclosed by housing 42.

As shown, first side 24 of die pad 26 faces first surface 44 of housing 42 and second side 30 of die pad 26 faces second surface 46 of housing 42. In some examples, sensor die 22 is coupled to first side 24 of die pad 26 and the auxiliary components 28 are coupled to second side 30 of die pad 26. Additionally, sensor die 22 is laterally displaced way from notch region 56 toward third sidewall 52, which is positioned opposite from first sidewall 48. This particular location of sensor die 22 within housing 42 enables the sensitive area (e.g., a reading point of a magnetic sensor) to be close to first surface 44 of sensor package 20, and ultimately close to an external surface of a sensor assembly that includes sensor package 20, as will be discussed in detail below. Further, notch region 56 may positioned between first and second connector pins 32, 34 and first and second connector pins 32, 34 may be equipped with crimp baskets 58 to facilitate fabrication operations, again as will be discussed in detail below.

In some examples sensor die 22 may be a magnetic field sensor and auxiliary component(s) 28 may include a magnet. Sensor die 22 may further include the magnetic field sensor integrated with application specific circuitry as a single block or unit. The magnetic field sensor may be sensitive to the motion of, for example, ferrous gear wheels and may therefore be implemented in a speed sensor application. Due to the effect of flux bending, the different directions of magnetic field lines from magnet 28 cause a variable electrical signal at sensor die 22. Because of a chosen orientation of sensor die 22 and a direction of ferrite magnetization of magnet 28, sensor die 22 may be sensitive to motion of, for example, a ferrous gear wheel primarily in front of sensor die 22, e.g., at first surface 44 of sensor package 20. The application specific circuitry may suitably condition the signal from the magnetic field sensor to output an electrical signal indicative of the sensed magnetic field using two connector pins 32, 34. The integrated capacitor 38 between first and second connector pins 32, 34 may provide immunity to and emission of electromagnetic disturbances.

Sensor die 22 may be implemented within an antilock braking system (ABS) or another vehicular speed sensing system. Such speed sensor integrated circuits may be overmolded with an overmold material (e.g., a thermoplastic or thermosetting polymer) to thereby form a sensor assembly to protect the various components from a harsh operational environment in which it will be used and to provide a mounting feature for attaching the sensor assembly in a predetermined location. In prior art sensor assemblies, sensor package 20 is coupled to a plastic support or carrier of some sort to retain sensor package 20 in position, then sensor package 20 is overmolded with an overmold material to provide the final sensor assembly. Examples implementing sensor die 22 with notch region 56 and integral first and second connector pins 32, 34 allow for a reduction in complexity and costs of the resulting sensor assembly by removing the need for a support or carrier, enabling enhanced reliability of the sensor assembly through a reduction in the potential for delamination, and so forth. Although a magnetic field sensor for use in a speed sensor application is described herein, other sensor assembly designs may be envisioned in which a sensor package with a notch region and integral connector pins may be overmolded to form a sensor assembly without first coupling the sensor assembly to a plastic support or carrier.

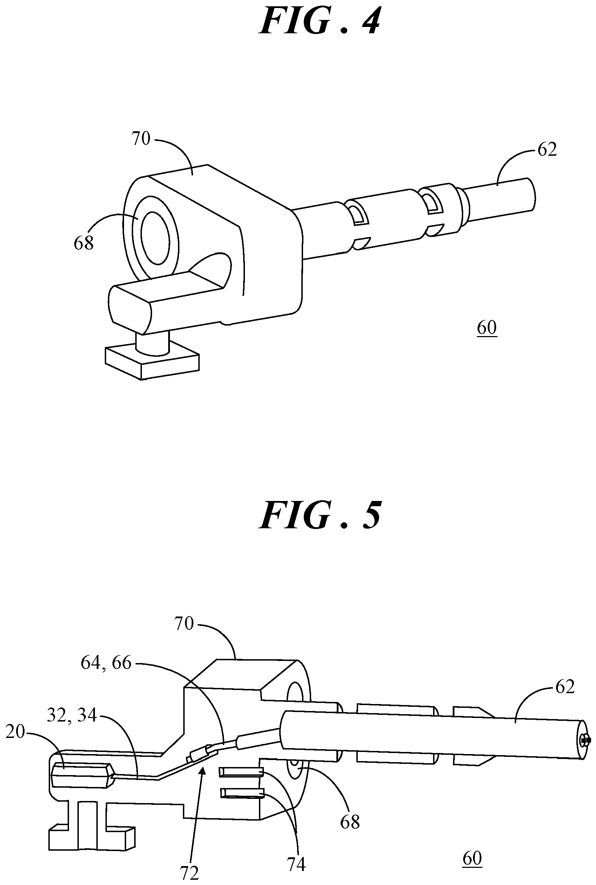

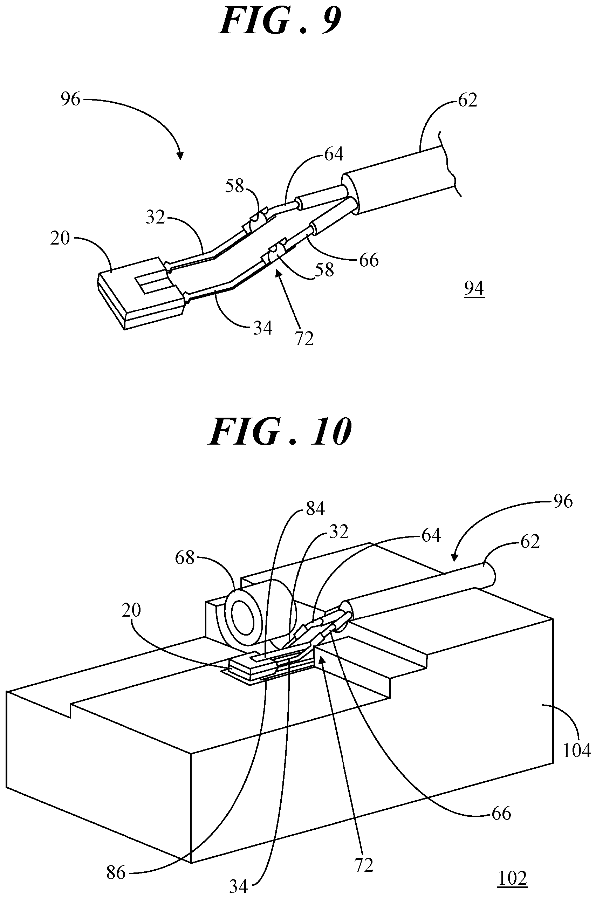

Referring now to FIGs. 4 and 5, FIG. 4 shows a perspective view of a sensor assembly 60 in accordance with an example and FIG. 5 shows a side sectional view of sensor assembly 60. The side sectional view of sensor assembly 60 provided in FIG. 5 enables the visualization of the internal components of sensor assembly 60. Sensor assembly 60 includes sensor package 20 as described in detail above. Sensor assembly 60 further includes a cable 62 having first and second conductors 64, 66 (individually distinguishable in FIG. 9) coupled to respective first and second connector pins 32, 34 (again individually distinguishable in FIG. 9). In some configurations, sensor assembly 60 may further include a retainer ring 68 (which may be a metal bushing or other mounting feature) for mounting in an end-use application. An overmold material 70 (e.g., a thermoplastic or thermosetting polymer) is overmolded about sensor package 20, an end 72 of cable 62 at the interconnection of first and second conductors 64, 66 with first and second connector pins 32, 34, and retainer ring 68. Overmold material 70 may be any suitable material that can flow well during an overmolding process and can achieve suitably thin walls often required in certain applications, such as, for example, speed sensor applications.

As mentioned previously, notch region 56 (FIG. 1) in housing 42 of sensor package 20 is sized to receive an alignment bar (described below) of an alignment tool implemented with a mold tool during an overmolding process. The alignment bar is configured to reside in notch region 56 during the overmolding process. As will be discussed below, the alignment tool may further include another alignment bar (described below) configured to reside against second surface 46 of housing 42 of sensor package 20. The alignment bars are configured to hold sensor package 20 in the mold tool during the overmolding process. Further, the alignment bars are configured to be retracted away from sensor package 20 following an initial phase of the overmolding process, but may remain in the mold tool such that the alignment bars are partially overmolded with overmold material 70. Following the overmolding process, the alignment bars may be removed from overmold material 70 such that markings 74 of the alignment bars remain in overmold material 70. Hence, markings 74 are residual features that may remain following fabrication of sensor assembly 60.

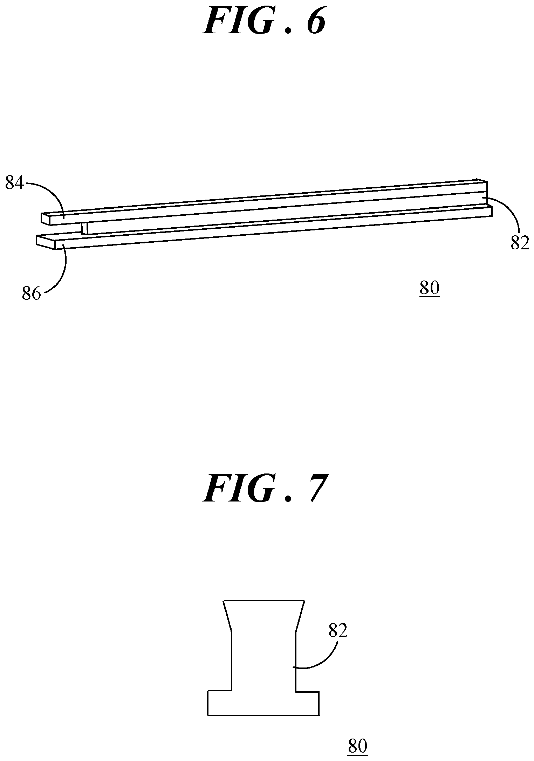

Referring to FIGs. 6-7, FIG. 6 shows a perspective view of an alignment tool 80 for retaining sensor package 20 (FIG. 3) in a mold tool during overmolding to produce sensor assembly 60 (FIG. 4) and FIG. 7 shows a rear, plan view of alignment tool 80. In general, alignment tool 80 includes a beam structure 82 having first and second alignment bars 84, 86 extending from an end of beam structure 82. Alignment tool 80 is configured to be seated in a similarly shaped opening within a mold tool, first alignment bar 84 is configured to be received in notch region 56 (FIG. 1) of sensor package 20, and second alignment bar 86 is configured to be placed against second surface 46 (FIG. 1) of housing 42 of sensor package 20. Alignment tool 80 will be further discussed in connection with fabrication methodology for sensor assembly 60 (FIG. 4).

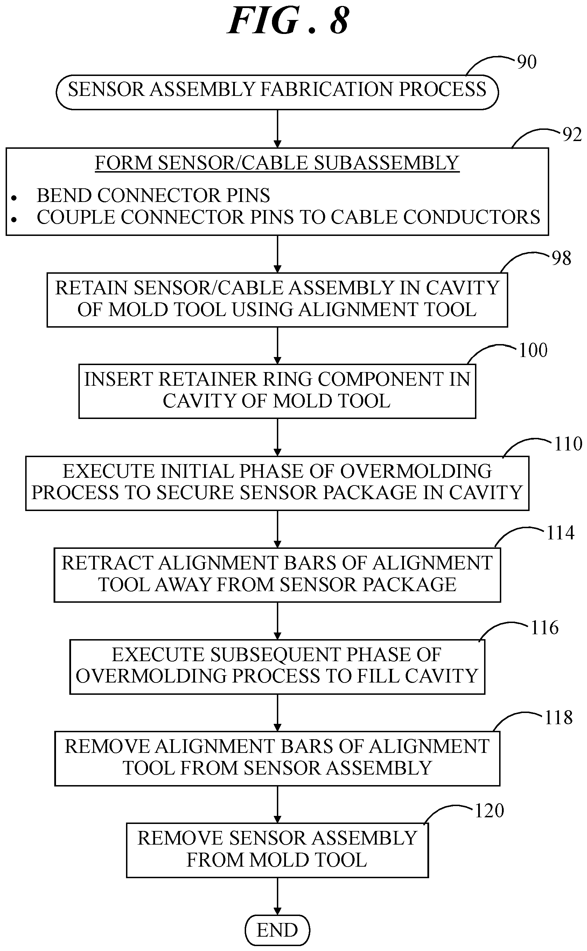

FIG. 8 shows a flowchart of a sensor assembly fabrication process 90 in accordance with the present invention. Sensor assembly fabrication process 90 provides an overview of the operations implemented to form sensor assembly 60.

At a block 92, a sensor/cable subassembly is formed. Referring to FIG. 9 in conjunction with fabrication block 92, FIG. 9 shows an initial stage 94 of sensor assembly fabrication process 90. Formation of a sensor/cable subassembly 96 may entail suitably bending first and second connector pins 32, 34 and coupling first and second connector pins 32, 34 to first and second cable conductors 64, 66. Accordingly, as shown in FIG. 9, first and second connector pins 32, 34 are bent in a predetermined configuration and crimp baskets 58 of first and second connector pins are coupled to first and second conductors 64, 66 of cable 62 to yield sensor/cable subassembly 96. First and second connector pins 32, 34 may be suitably bent to limit the stress imposed on sensor package 20 in case of unintended bending during handling. Crimp baskets 58 are suitably bent or deformed to securely couple first and second connector pins 32, 34 to first and second conductors 64, 66. Although a crimping technique is discussed herein, alternative embodiments may employ soldering, welding, or any other appropriate coupling technique.

With reference back to fabrication process 90 of FIG. 8, at a block 98, the sensor/cable subassembly is retained in a cavity of a mold tool using the alignment tool and at a block 100, retainer ring 68 is inserted in the cavity of the mold tool. Referring now to FIG. 10, FIG. 10 show a subsequent stage 102 of fabrication process 90 following initial stage 94 illustrated in FIG. 9. As shown, sensor/cable subassembly 96 is retained in a mold tool 104 (only a portion of which is shown). Thus, first and second connector pins 32, 34 are bent in the predetermined configuration and first and second connector pins 32, 34 are coupled to first and second conductors 64, 66 of cable 62 prior to retaining the end 72 of cable 62 in mold tool 104. Additionally, retainer ring 68 is inserted in mold tool 104.

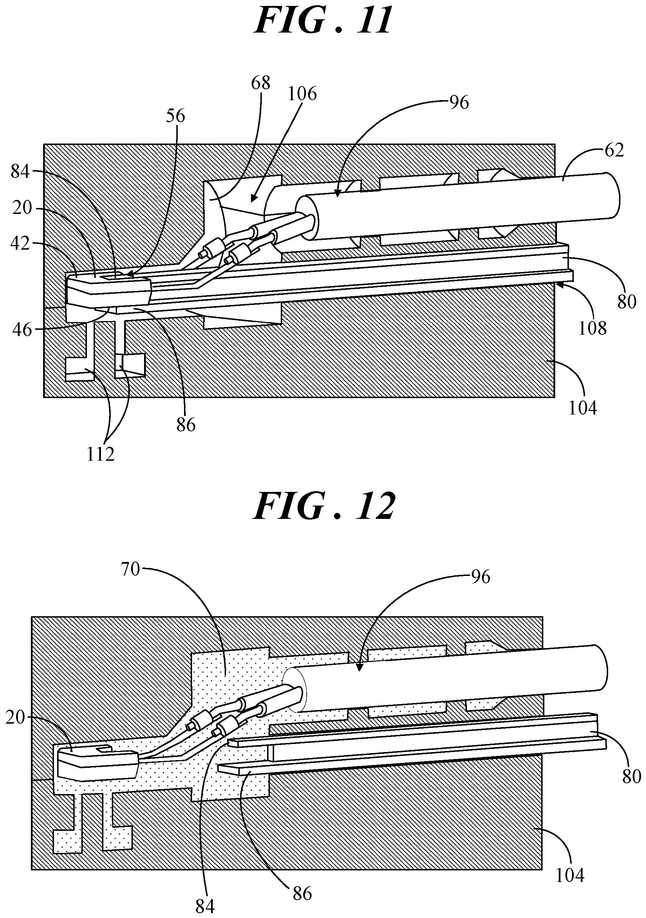

Referring to FIGs. 10-11, FIG. 11 shows a side perspective view of sensor/cable subassembly 96 and retainer ring 68 in mold tool 104. As shown, mold tool 104 is closed to form a cavity 106 in which sensor/cable subassembly 96 and retainer ring 68 are located. In order to better distinguish cavity 105, mold tool 104 is shaded with rightward and downward directed hash marks in FIG. 11. Alignment tool 80 extends through an opening 108 through mold tool 104 such that first and second alignment bars 84, 86 are also located in cavity 106. First alignment bar 84 of alignment tool 80 is received in notch region 56 of sensor package 20 and second alignment bar 86 is placed against second surface 46 of housing 42 of sensor package 20 to retain sensor package 20 in cavity 106 of mold tool 104. In other configurations, an alignment tool may only have first alignment bar 84, but not second alignment bar 86. In such a case, only first alignment bar 84 would be used to retain sensor package 20 in cavity 106 of mold tool 104.

With reference back to fabrication process 90 of FIG. 8, an initial phase of an overmolding process is executed to secure sensor package 20 in cavity 106 at a block 110. Referring briefly to FIG. 11, a gate (entrance into cavity 106) for passage of overmold material 70 (FIG. 4) may be provided at an alignment pin region 112 of mold tool 104. At that gate location, overmold material 70 (FIG. 7) would initially fill cavity 106 at the location of sensor package 20 to fix sensor package 20 by overmold material 70. The presence of first and second alignment bars 84, 86 holds sensor package 20 in place so that the flow of overmold material 70 will not push the sensor package 20 out of place.

With reference back to FIG. 8, after cavity 106 is partially filled to secure sensor package 20, fabrication process 90 continues with a block 114. At block 114, first and second alignment bars 84, 86 of alignment tool 80 are retracted away from sensor package 20. Following retraction of first and second alignment bars 84, 86 at block 114, sensor assembly fabrication process 90 continues with a block 116. At block 116, a subsequent phase of the overmolding process is executed to fill cavity 106. That is, the overmolding process continues following retraction of first and second alignment bars 84, 86 to completely fill cavity 106.

Referring to FIG. 12 in connection with block 114 of fabrication process 90, FIG. 12 shows a side perspective view of sensor/cable subassembly 96 in mold tool 104 following the overmolding process of blocks 110, 116. Overmold material 70 is represented in FIG. 12 by a light stippled pattern. As shown, first and second alignment bars 84, 86 of alignment tool 80 have been retracted away from sensor package 20 and overmold material 70 surrounds sensor/cable subassembly 96, and first and second alignment bars 84, 86. Overmold material 70 also surrounds retainer ring 68 (not visible in FIG. 12).

With reference back to fabrication process 90 of FIG. 8, following completion of the overmolding process at block 116, fabrication process 90 continues with blocks 118, 120. At block 118, first and second alignment bars 84, 86 are removed from the overmolded sensor assembly within mold tool 104 and at block 120, sensor assembly 60 (FIG. 4) is removed from mold tool 104. As discussed previously, markings 74 (FIG. 5) of first and second alignment bars 84, 86 may remain in an outer surface of overmold material 70 of sensor assembly 60. In an alternative embodiment, after first and second alignment bars 84, 86 are removed, the subsequent markings 74 or openings that may extend in proximity to the sensor package may be suitably sealed with, for example, a potting compound to prevent or largely limit ingress of contaminants into the sensor assembly.

Thus, execution of sensor assembly fabrication process 90 enables the implementation of a direct overmolding technique that does not require overmolding a support or carrier into the sensor assembly. This is accomplished by equipping the sensor package with a special feature (e.g., the notch region) which is used for alignment and secure retention of the sensor package using alignment bar of an alignment tool during the overmolding process. It should be understood that certain ones of the process blocks depicted in FIG. 8 may be performed in parallel with each other or with performing other processes. In addition, the particular ordering of the process blocks depicted in Fig. 8 may be modified, while achieving substantially the same result. Accordingly, such modifications are intended to be included within the scope of the inventive subject matter.

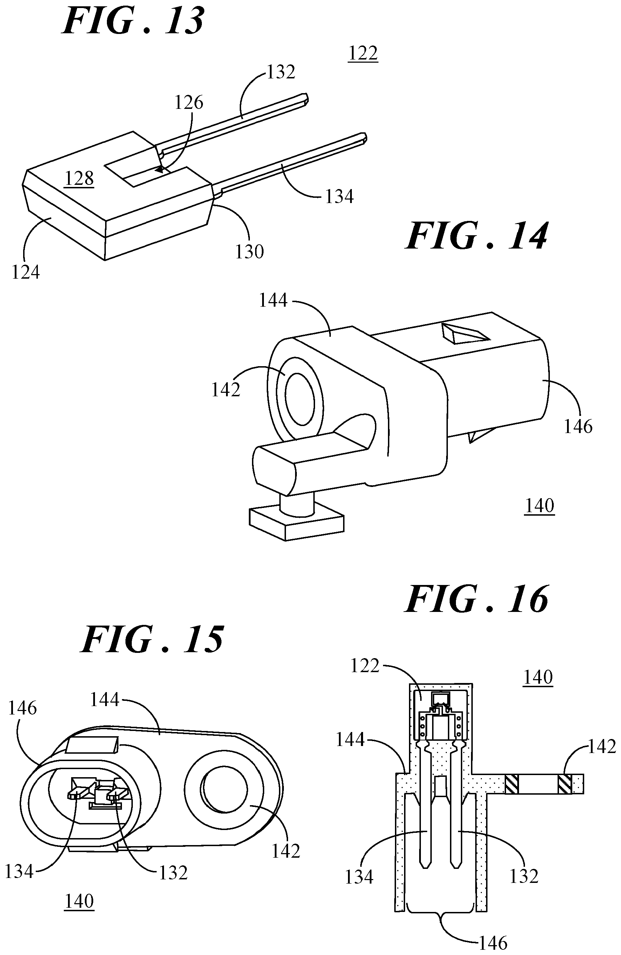

FIG. 13 shows a perspective view of a sensor package 122 in accordance with an example not forming part of the present invention. A housing 124 of sensor package 122 includes a notch region 126 formed therein ( similar to notch region 56 shown in FIGs. 1-3) that is configured to receive first alignment bar 84 (FIG. 6) of alignment tool 80 (FIG. 6). Notch region 126 of housing 124 extends into a first surface 128 of housing 124 such that a material portion of housing 124 is absent at a first sidewall 130 of housing 124 and at first surface 128 of housing 124. Notch region 126 is again located between first and second connector pins 132, 134 of sensor package 122. In contrast to sensor package 20 (FIGs. 1-3), first and second connector pins 132, 134 of sensor package 122 are straight (i.e., do not have crimp baskets 58). Thus, connector pins 132, 134 may be used as a direct connection to a separate element or cable (discussed below). The internal components of sensor package 122 may be similar to those described above in connection with FIGs. 1-3. Hence, their description will not be repeated herein for brevity.

Referring to FIGs. 14-16, FIG. 14 shows a perspective view of another sensor assembly 140, FIG. 15 shows a rear perspective view of sensor assembly 140, and FIG. 16 shows a sectional view of sensor assembly 140. Sensor assembly 140 includes sensor package 122 and a retainer ring 142. An overmold material 144 (e.g. a thermoplastic or thermoset polymer) is overmolded about sensor package 122 and retainer ring 142 to form sensor assembly 140. In the illustrated example which does not form part of the present invention, the straight first and second connector pins 132, 134 extend out of overmold material 144 and reside in a connector basket 146. In use, connector pins 132, 134 may be connected to a receiving part (e.g., cable, secondary structure, and so forth in accordance with a particular design, not shown) to provide electrical connection to sensor package 122.

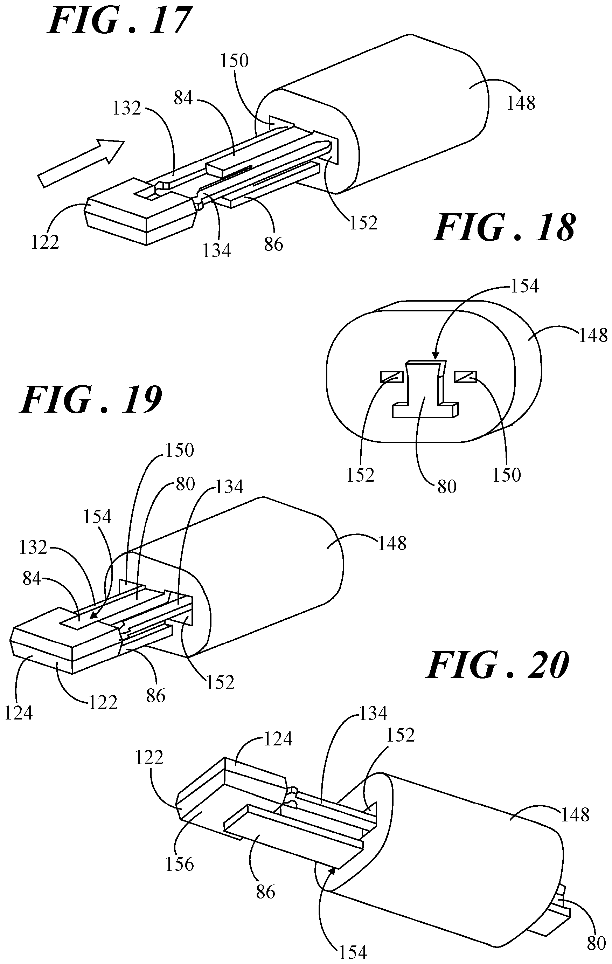

Referring to FIGs. 17-18, FIG. 17 shows a perspective view of sensor package 122 being inserted into a pin support 148 and FIG. 18 shows a rear perspective view of pin support 148. Pin support 148 is generally sized to yield connector basket 146 (FIGs. 14-16) during an overmolding process. Pin support 148 includes receiving features 150, 152 into which first and second connector pins 132, 134 can be inserted (denoted by an arrow in FIG. 17) prior to overmolding. Pin support 148 further includes an opening 154 extending through it and located between receiving features 150, 152. Opening 154 may be sized to accommodate passage of alignment tool 80 so that first and second alignment bars 84, 86 can be utilized during an overmolding process to retain sensor package 122 in a mold tool (not shown) to form sensor assembly 140 (FIGs. 14-16).

With reference to FIGs. 19-20, FIG. 19 shows a perspective view of sensor package 122 retained by alignment tool 80 and FIG. 20 shows another perspective view of sensor package 122 retained by alignment tool 80. More particularly, first and second connector pins 132, 134 are seated in receiving features 150, 152 of pin support 148 and alignment tool 80 has been passed through opening 154 in pin support 148. First alignment bar 84 is received in notch region 126 of sensor assembly 122 and second alignment bar 86 is placed against a second surface 156 of housing 124 of sensor package. Thus, sensor assembly 122, pin support 148, and alignment tool 80 can then be positioned in a mold tool (not shown) adapted to receive sensor assembly 122 and pin support 148 (not shown) for undergoing an overmolding process. The process steps of sensor assembly fabrication process 90 (FIG. 8) may be performed with sensor assembly 122 held by pin support 148 (in lieu of sensor/cable subassembly 96, FIG. 9) and retained in the cavity of a mold tool using alignment tool 80.

Thus, embodiments described herein use a direct overmolding technique that does not require a premolded support in the sensor assembly. In particular, the sensor package is equipped with a notch region that can be used for alignment and secure retention of the sensor package during an overmolding process. The notch region is at the die side of the sensor package and is deep enough to accommodate an alignment bar of an alignment tool used with the mold tool. This can ensure that the sensitive area of the sensor package (e.g., the reading point of the sensor) is close to the surface of the overmolded sensor assembly. Further, the sensor package can be equipped with connector pins. In some embodiments, the connector pins may be connected with conductors of a cable, and this connection junction may also be overmolded with the overmold material for protection of the connection junction from an external environment. The various inventive concepts and principles embodied in the sensor package, sensor assembly, and method of fabrication may thus enable improved fabrication and cost efficiency, as well as enhanced sensor reliability.

The foregoing description is not intended to be exhaustive or to limit the invention to the precise form disclosed. Modifications or variations are possible in light of the above teachings. The embodiments) was chosen and described to provide the best illustration of the principles of the invention and its practical application, and to enable one of ordinary skill in the art to utilize the invention in various embodiments and with various modifications as are suited to the particular use contemplated. The scope of the invention is determined by the appended claims.

### 82129753EP03 REFERENCE NUMBERS

- 20: sensor package
- 22: sensor die
- 24: first side
- 26: die pad
- 28: one or more auxiliary components
- 30: second side
- 32: first connector pin
- 34: second connector pin
- 36: bond wires
- 38: capacitor
- 40: distal ends
- 42: housing
- 44: first surface
- 46: second surface
- 48: first sidewall
- 50: second sidewall
- 52: third sidewall
- 54: fourth sidewall
- 56: notch region
- 58: crimp baskets
- 60: sensor assembly
- 62: cable
- 64: first conductor
- 66: second conductor
- 68: retainer ring
- 70: overmold material
- 72: end
- 74: markings
- 76: -
- 78: -
- 80: alignment tool
- 82: beam structure
- 84: first alignment bar
- 86: second alignment bar
- 88: -
- 90: sensor assembly fabrication process
- 92: block
- 94: initial stage
- 96: sensor/cable subassembly
- 98: block
- 100: block
- 102: subsequent stage
- 104: mold tool
- 106: cavity
- 108: opening
- 110: block
- 112: alignment pin region
- 114: block
- 116: block
- 118: block
- 120: block
- 122: sensor package
- 124: housing
- 126: notch region
- 128: first surface
- 130: first sidewall
- 132: first connector pin
- 134: second connector pin
- 136: -
- 138: -
- 140: sensor assembly
- 142: retainer ring
- 144: overmold material
- 146: connector basket
- 148: pin support
- 150: receiving feature
- 152: receiving feature
- 154: opening
- 156: second surface

## Claims

1. A method (90) for forming a sensor assembly (60) comprising:
retaining (98) a sensor package (20) in a cavity (106) of a mold tool (104), the sensor package including a sensor die (22), connector pins (32, 34) electrically connected to the sensor die, and a housing (42) in which the sensor die is located, the housing having first and second surfaces (44, 46) spaced apart from one another by first, second, third, and fourth sidewalls (48, 50, 52, 54), wherein the connector pins extend from the first sidewall of the housing, and the housing includes a notch region (56) extending into the first surface of the housing such that a material portion of the housing is absent at the first sidewall and at the first surface of the housing, the retaining operation comprising receiving an alignment bar (84) of an alignment tool (80) in the notch region; and
performing (110, 116) an overmolding process to fill the cavity with an overmold material (70) to form the sensor assembly, wherein the alignment bar is configured to hold the sensor package in the mold tool during the overmolding process;
wherein the performing operation comprises:
executing (110) an initial phase of the overmolding process to secure the sensor package (20) in the mold tool (104) with the overmold material (70);
retracting (114) the alignment bar (84) away from the sensor package following the initial phase of the overmolding process; and
executing (116) a subsequent phase of the overmolding process following the retracting operation, the subsequent phase being performed to fill the cavity (106) of the mold tool with the overmold material, and the subsequent phase partially overmolding the alignment bar with the overmold material.

2. The method (90) of claim 1 wherein the alignment bar (84) is a first alignment bar, and the method further comprises placing (98) a second alignment bar (86) of the alignment tool (80) against the second surface (46) of the housing (42) such that the first and second alignment bars operate cooperatively to retain the sensor package (20) in the mold tool (104) during the overmolding process.

3. The method (90) of claim 1 further comprising removing (118) the alignment bar (84) from the overmold material (70) following the subsequent phase of the overmolding process such that a marking (74) of the alignment bar remains in the overmold material.

4. The method (90) of any preceding claim wherein:
prior to the retaining operation (98), coupling (92) first and second ones of the connector pins (32, 34) to respective first and second conductors (64, 66) of a cable (62); and
the retaining operation further comprises retaining an end (72) of the cable at the interconnection of the first and second conductors with the first and second ones of the connector pins in the cavity (106) of the mold tool (104).

5. The method (90) of claim 4 further comprising bending (92) the first and second ones of the connector pins (32, 34) in a predetermined configuration prior to the retaining the end of the cable in the cavity (106) of the mold tool (104).

6. The method (90) of any preceding claim wherein following the performing operation, a distal end of each of the connector pins (132, 134) extends out of the overmold material (144).

7. The method (90) of any preceding claim further comprising inserting a retainer ring component (68) in the cavity (106) of the mold tool (104) such that the retainer ring component is overmolded with the overmold material (70).

## Patentansprüche

1. Verfahren (90) zum Bilden einer Sensorbaugruppe (60), umfassend:
Festhalten (98) eines Sensor-Package (20) in einem Hohlraum (106) eines Formwerkzeugs (104), wobei das Sensor-Package einen Sensor-Die (22), Verbinderpins (32, 34), die elektrisch mit dem Sensor-Die verbunden sind, und ein Gehäuse (42), in dem sich der Sensor-Die befindet, enthält, wobei das Gehäuse eine erste und zweite Oberfläche (44, 46) aufweist, die voneinander durch eine erste, zweite, dritte und vierte Seitenwand (48, 50, 52, 54) beabstandet sind, aufweist, wobei sich die Verbinderpins von der ersten Seitenwand des Gehäuses erstrecken und das Gehäuse ein Kerbgebiet (56) enthält, das sich derart in die erste Oberfläche des Gehäuses erstreckt, dass ein Materialabschnitt des Gehäuses an der ersten Seitenwand und an der ersten Oberfläche des Gehäuses fehlt, wobei die Festhalteoperation das Aufnehmen einer Ausrichtstange (84) eines Ausrichtwerkzeugs (80) in dem Kerbgebiet umfasst; und
Durchführen (110, 116) eines Überformungsprozesses zum Füllen des Hohlraums mit einem Überformungsmaterial (70) zum Bilden der Sensorbaugruppe, wobei die Ausrichtstange ausgelegt ist zum Festhalten des Sensor-Package in dem Formwerkzeug während des Überformungsprozesses;
wobei die Durchführungsoperation umfasst:
Ausführen (110) einer Anfangsphase des Überformungsprozesses zum Sichern des Sensor-Package (20) in dem Formwerkzeug (104) mit dem Überformungsmaterial (70);
Zurückziehen (114) der Ausrichtstange (84) weg von dem Sensor-Package nach der Anfangsphase des Überformungsprozesses; und
Ausführen (116) einer nachfolgenden Phase des Überformungsprozesses nach der Zurückziehoperation, wobei die nachfolgende Phase durchgeführt wird zum Füllen des Hohlraums (106) des Formwerkzeugs mit dem Überformungsmaterial und die nachfolgende Phase die Ausrichtstange mit dem Überformungsmaterial teilweise überformt.

2. Verfahren (90) nach Anspruch 1, wobei die Ausrichtstange (84) eine erste Ausrichtstange ist und das Verfahren weiter das Platzieren (98) einer zweiten Ausrichtstange (86) des Ausrichtwerkzeugs (80) gegen die zweite Oberfläche (46) des Gehäuses (42) derart umfasst, dass die erste und zweite Ausrichtstange zusammenarbeiten, um das Sensor-Package (20) während des Überformungsprozesses in dem Formwerkzeug (104) festzuhalten.

3. Verfahren (90) nach Anspruch 1, weiter umfassend das Beseitigen (118) der Ausrichtstange (84) von dem Überformungsmaterial (70) nach der nachfolgenden Phase des Überformungsprozesses, so dass eine Markierung (74) der Ausrichtstange in dem Überformungsmaterial verbleibt.

4. Verfahren (90) nach einem vorhergehenden Anspruch, wobei:
vor der Festhalteoperation (98) das Koppeln (92) von ersten und zweiten der Verbinderpins (32, 34) an jeweilige erste und zweite Leiter (64, 66) eines Kabels (62); und
die Festhalteoperation weiter das Festhalten eines Endes (72) des Kabels an der Zwischenverbindung der ersten und zweiten Leiter mit den ersten und zweiten der Verbinderpins in dem Hohlraum (106) des Formwerkzeugs (104) umfasst.

5. Verfahren (90) nach Anspruch 4, weiter umfassend das Biegen (92) der ersten und zweiten der Verbinderpins (32, 34) in einer vorbestimmten Konfiguration vor dem Festhalten des Endes des Kabels in dem Hohlraum (106) des Formwerkzeugs (104).

6. Verfahren (90) nach einem vorhergehenden Anspruch, wobei nach der Durchführoperation sich ein distales Ende jedes der Verbinderpins (132, 134) aus dem Überformungsmaterial (144) heraus erstreckt.

7. Verfahren (90) nach einem vorhergehenden Anspruch, weiter umfassend das Einführen einer Festhalteringkomponente (68) in den Hohlraum (106) des Formwerkzeugs (104), so dass die Festhalteringkomponente mit dem Überformungsmaterial (70) überformt wird.

## Revendications

1. Procédé (90) de mise en forme d'un ensemble capteur (60) comprenant :
la retenue (98) d'un bloc capteur (20) dans une cavité (106) d'un outil de moulage (104), le bloc capteur comportant une puce de capteur (22), des broches de connecteur (32, 34) connectées électriquement à la puce de capteur, et un boîtier (42) dans lequel la puce de capteur est située, le boîtier ayant des première et deuxième surfaces (44, 46) espacées l'une de l'autre par des première, deuxième, troisième, et quatrième parois latérales (48, 50, 52, 54), les broches de connecteur s'étendant depuis la première paroi latérale du boîtier, et le boîtier comportant une région d'encoche (56) s'étendant dans la première surface du boîtier de telle sorte qu'une portion de matériau du boîtier ne figure pas au niveau de la première paroi latérale et au niveau de la première surface du boîtier, l'opération de retenue comprenant la réception d'une barre d'alignement (84) d'un outil d'alignement (80) dans la région d'encoche ; et
la réalisation (110, 116) d'un processus de surmoulage pour remplir la cavité avec un matériau de surmoulage (70) afin de mettre en forme l'ensemble capteur, la barre d'alignement étant configurée pour maintenir le bloc capteur dans l'outil de moulage pendant le processus de surmoulage ;
l'opération de réalisation comprenant :
l'exécution (110) d'une phase initiale du processus de surmoulage afin de fixer le bloc capteur (20) dans l'outil de moulage (104) avec le matériau de surmoulage (70) ;
la rétractation (114) de la barre d'alignement (84) du bloc capteur à la suite de la phase initiale du processus de surmoulage ; et
l'exécution (116) d'une phase subséquente du processus de surmoulage à la suite de l'opération de rétractation, la phase subséquente étant réalisée pour remplir la cavité (106) de l'outil de moulage avec le matériau de surmoulage, et la phase subséquente surmoulant partiellement la barre d'alignement avec le matériau de surmoulage.

2. Procédé (90) selon la revendication 1, la barre d'alignement (84) étant une première barre d'alignement, et le procédé comprenant en outre le placement (98) d'une deuxième barre d'alignement (86) de l'outil d'alignement (80) contre la deuxième surface (46) du boîtier (42) de telle sorte que les première et deuxième barres d'alignement fonctionnent de manière coopérative afin de retenir le bloc capteur (20) dans l'outil de moulage (104) pendant le processus de surmoulage.

3. Procédé (90) selon la revendication 1, comprenant en outre le retrait (118) de la barre d'alignement (84) du matériau de surmoulage (70) à la suite de la phase subséquente du processus de surmoulage de telle sorte qu'une marque (74) de la barre d'alignement reste dans le matériau de surmoulage.

4. Procédé (90) selon l'une quelconque des revendications précédentes,
avant l'opération de retenue (98), le couplage (92) de première et deuxième des broches de connecteur (32, 34) à des premier et deuxième conducteurs (64, 66) respectifs d'un câble (62) ; et
l'opération de retenue comprenant en outre la retenue d'une extrémité (72) du câble au niveau l'interconnexion des premier et deuxième conducteurs avec les première et deuxième des broches de connecteur dans la cavité (106) de l'outil de moulage (104).

5. Procédé (90) selon la revendication 4, comprenant en outre le recourbement (92) des première et deuxième des broches de connecteur (32, 34) dans une configuration prédéterminée avant la retenue de l'extrémité du câble dans la cavité (106) de l'outil de moulage (104).

6. Procédé (90) selon l'une quelconque des revendications précédentes, à la suite de l'opération de réalisation, une extrémité distale de chacune des broches de connecteurs (132, 134) s'étendant en dehors du matériau de surmoulage (144).

7. Procédé (90) selon l'une quelconque des revendications précédentes, comprenant en outre l'insertion d'un composant en anneau de retenue (68) dans la cavité (106) de l'outil de moulage (104) de telle sorte que le composant en anneau de retenue est surmoulé avec le matériau de surmoulage (70).
